# EUROPEAN PATENT SPECIFICATION

(11) **EP 0 472 269 B1**
(45) Date of publication and mention of the grant of the patent: **30.08.1995**
(21) Application number: 91305394.8
(22) Date of filing: 14.06.1991
(51) Int. Cl.: H05K 7/20

(54) **Cooled electrical apparatus**
Gekühltes elektrisches Gerät
Appareil électrique refroidi

(30) Priority: 21.08.1990 US 570441
(43) Date of publication of application: 26.02.1992
(73) Proprietor: International Business Machines Corporation, Armonk, N.Y. 10504 (US)
(72) Inventor: Mizzi, John Vincent, Poughkeepsie, New York 12603 (US)
(74) Representative: Bailey, Geoffrey Alan

(56) References cited:
- DE-A- 2 345 626
- GB-A- 2 153 990
- ELECTRONIC PACKAGING AND PRODUCTION, vol. 28, no. 5, May 1988, NEWTON, MASSACHUSETTS US page 121; 'Liquid Heat Sink'

## Description

This invention relates generally to the field of housing and mounting electrical components. More particularly, this invention relates to the cooling of closely packed circuit boards.

Integrated circuit technology enables circuit manufacturers to place increasingly large numbers of electrical devices into smaller silicon chips. Similarly, these chips are packaged and mounted on an increasingly higher density circuit board. The larger number of devices within a smaller area of circuit board has led to significant advances in circuit performance. It has also led to significant problems associated with maintaining the circuits in a low enough temperature range to enable the circuits to operate at such high performance. Typically, the circuits and circuit boards are cooled by forced air. However, efficiently removing heat from circuit boards requires a high degree of uniformity across the boards and a high heat removal rate. Forced air systems have difficulty meeting these requirements as the circuit density becomes greater. Specifically, a relatively large space between the boards is required to permit sufficient air flow between the boards. Also, two edges of the boards must be left open (i.e. free of obstructions such as interconnections) to permit the air to pass between the boards and cool the board surfaces. This decreases the interconnectivity between boards because those two sides are not available for electrical connections.

Prior art attempts to cool high density integrated circuitry have primarily focused on two areas. The first area is immersing the integrated circuits into a coolant while the circuits are in operation. The advantage of this method of cooling is that the heat transfer coefficient of the coolant can be several orders of magnitude greater than that of air. The coolant can remove greater amounts of heat and therefore more easily maintain the temperature of the circuits within a suitable range. The problem with this method of cooling is that the coolant itself can affect the electrical performance and reliability of the integrated circuit. Immersion in a coolant requires the circuit connections and the circuits to be resistant to not only the immersion in the coolant but also the corrosive effects of the coolant.
Additionally, immersion in a container requires a complete shutdown of the system to service a single board in a multi-board system. This is an expensive and complicated method to cool and service the electrical system.

A second focus area in the prior art involves placing integrated circuits adjacent to heat conducting metal bodies which contain a fluid flow. The fluid flow removes the heat but does not immerse the integrated circuit in the coolant. The advantage of this system is that it avoids the reliability problems of immersing the circuits in the coolant. The problem with this method of cooling is that it is not as efficient in removing heat from the circuits as the immersion technique. The reason for this lack of cooling efficiency is that the metal body does not contact a sufficient area of the integrated circuits to rapidly transfer heat away from the integrated circuit. The lack of cooling surface area results from the complexity of producing a heat sink for an entire circuit board. That is, merely the tops of circuit modules are cooled because it is too difficult to cheaply manufacture fluid channels for the entire topology of the board. Fluid channels are also only typically used on large planar boards in order to minimize the number of fluid channel/board assemblies for packaging a given number of electronic modules. This results in long signal transmission times because signals are transmitted over a long distance on a single board rather than over a shorter distance between different boards. A three dimensional array of interconnected boards shortens signal times when compared to two dimensional planar wiring.

Electrical apparatus is known with a cooling system for cooling spaced circuit boards, comprising; a plurality of circuit boards; and a plurality of coolant membranes, each having at least one inlet and at least one outlet tube for circulating a coolant fluid through said coolant membrane; each said coolant membrane having opposing conformable walls for at least partially conforming under pressure to the surface topology of respective opposing surfaces of said circuit boards. Since the walls of the coolant membrane are of relatively thin material, they may move towards one another under the urging of the pressurised coolant. Such apparatus is disclosed in GB 2,153,990A.

According to this invention as defined in claim 1, the apparatus comprises a plurality of motherboards, each of said motherboards having a plurality of connections for connecting at least one edge of each of said circuit boards to said motherboard; a frame supporting said circuit boards and said motherboards, said frame having a plurality of side rails attaching adjacent motherboard edges together forming a housing to enclose said plurality of circuit boards; each said coolant membrane being interposed in a gap formed by two adjacent circuit boards; the arrangement being such that in operation circulation of said coolant fluid pressurizes said coolant membranes between said circuit boards to conform said opposing walls to said surface topology of said circuit boards.

This invention provides increased surface contact area for heat removal from circuit boards without exposing the circuit board components to the cooling fluid. This is accomplished by compressing a heat conductive membrane or bag between adjacent circuit boards. The flexible membrane contains coolant fluid which is pumped into and out of or through the flexible membrane. The membrane isolates the circuit card components from the coolant fluid and is flexible enough so that it conforms to the surface of individual circuit boards. The coolant fluid passing through the membrane uniformly removes heat from the circuit components because the flexibility of the membrane allows the components to act as baffles just as though the coolant was directly in contact with the circuit board. The membrane is also heat conductive so as to efficiently pass the heat from the board to the fluid. The higher the thermal conductivity of the membrane material, the lower the coolant flow rate which is required for the boards. Specifically, the membrane is preferably formed of a material which has a high thermal conductivity and has a high resistance to coolant permeability.

The individual membranes are sandwiched between adjacent boards and housed such that the combination of fluid pressure and board to board spacing maintain the conformity of the membrane to the circuit board surface.

Individual boards within the housing may be electrically connected with edge connectors on all four sides and can be separately removable from the housing. In at least a preferred embodiment, fluid flow to coolant membranes is maintained through the edges of the membranes and between the boards at the four corners of the boards. This lamination of cooling membranes between circuit boards, each with their individual edge electrical connections and cooling connections, allows for efficient packaging of the circuit components on the circuit board because of the high heat removal capability. Additionally, because the fluid flow is constrained to the corners of the coolant membrane, all four edges of the circuit boards are available for interconnection to other circuit boards. This added interconnection flexibility further enhances the packaging density of the invention.

In order that the invention may be fully understood a preferred embodiment thereof will now be described, by way of example only, with reference to the accompanying drawings in which:
Figure 1 illustrates a side view cross section of a board and membrane arrangement;
Figure 2 illustrates a section of a circuit card;
Figure 3 illustrates a package frame for circuit cards; and
Figure 4 illustrates a side rail for use with the package frame.

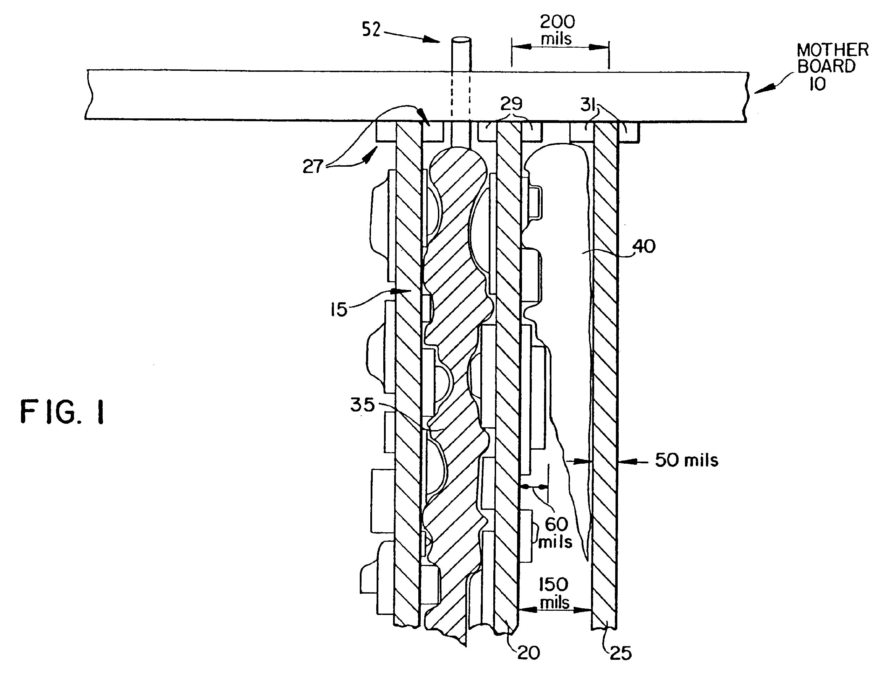

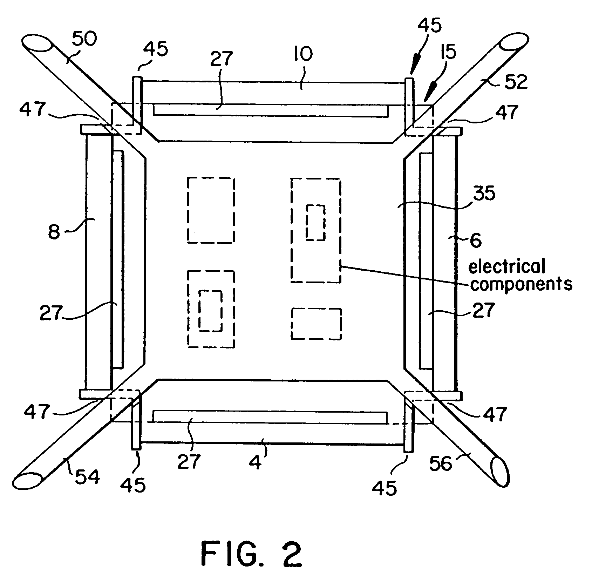

Figure 1 illustrates a cross section of a board and membrane arrangement. Top motherboard 10 contains edge connectors 27, 29, and 31 which couple to the top edge of circuit cards or boards 15, 20, and 25 respectively. Boards 15, 20, and 25 have integrated circuits mounted on one or both sides. Cooling membrane 35 is compressed between boards 15 and 20. Cooling membrane 40 is compressed between boards 20 and 25. Boards 15, 20, and 25 have side and bottom edges which couple to side motherboards 8, and 6 respectively, and to bottom motherboard 4 shown on Figure 2. Motherboards 4, 6, and 8 couple to the edge of boards 15, 20, and 25 in the same fashion as motherboard 10.

Figure 2 illustrates a side view of a section of the circuit card and motherboards. The motherboards 4, 6, 8, and 10, hold the integrated circuit board 15 through a plurality of edge connectors 27. Edge connectors 27, 29, and 31 typically (but not necessarily) connect both sides of the boards 15, 20, and 25 to the motherboards 4, 6, 8, and 10. The motherboards are mechanically connected to each other at the edges of the motherboards, through side rail members 45. The cooling membrane 35 lies against the circuit board 15. The cooling membrane 35 has four fluid tubes, 50, 52, 54, and 56. Each tube fits through openings 47 in the side rail members 45. Once outside the housing formed by the motherboards 4, 6, 8, and 10 and side rail members 45, the tubes are connected to a conventional coolant supply and pumping system (not shown). The pumping system is typically, but need not be, recirculating. Fluid tubes 50 and 52 pump cooling fluid into the cooling membrane 35. Fluid tubes 54 and 56 pump fluid out of the cooling membrane 35. The fluid can be a variety of fluids, including air, water, or dielectric liquids such as oils or chlorofluorocarbons. The fluid is pumped through the cooling membrane 35 and the membrane is in contact with the electrical components on the circuit board 15 so that the heat generated by the components is transmitted to the fluid and removed from the circuit board.

The electronic circuit board packing scheme shown in figures 1 and 2 is very efficient in removing heat from the circuit boards. The packaging scheme allows the spacing between boards to be very low. Therefore, the volumetric packing density of the electronic circuits is high when compared to conventional forced air cooled systems. One reason for this efficiency is the direct and confined forced fluid flow between circuit boards. The inlet nozzles, 50 and 52, and the outlet nozzles, 54 and 56, maintain active fluid flow between the circuit boards even though the circuit boards are closely spaced. In conventional systems, the close spacing of the circuit boards impede the direct flow of the coolant fluid (whether water, air, etc.) and so is a severe limit on the heat removal capability of the system.

The present packaging structure has a high volumetric density because the cooling fluid flow through the corners of the housing enables the circuit boards to utilize all four edges for board interconnections. Therefore, the electronic circuits can be packaged in a highly interconnected three dimensional configuration. The three dimensional interconnected structure reduces signal transmission delays caused by planar packaging used to maintain a proper temperature range for the circuits. The reduction in signal transmission delays provides a reduction in the power required to drive those signal delays and therefore, even a further increase in circuit cooling capacity.

The coolant membrane exerts a pressure against the circuit board surfaces. This pressure conforms the surface of the membrane to the circuit board surface. Pressurisation also forces fluid to flow between the circuit boards. Increasing the fluid pressure in turn increases the fluid flow rate so that the heat removal rate increases. The controlled fluid flow significantly increases the heat removal efficiency compared to prior art systems. Additionally, the coolant and the conforming membrane provide shielding to isolate the individual electrical components from stray electrical or magnetic fields emanating from adjacent or oppositely facing components.

In Figure 2, the fluid flow is from top to bottom and results from four nozzles, two top inlet nozzles and two bottom outlet nozzles. However, the number, placement, and size of the nozzles can be varied to provide increased flow rate or circulation. There could be an inlet and outlet nozzle on the top edge of the coolant membrane and an inlet and outlet nozzle on the bottom edge of the membrane for example. Another variation on nozzle placement is to place inlets on the sides and outlets on the top and bottom edge of the membrane. Additionally, the size of the nozzles can be varied to increase or decrease fluid flow. The shape of the nozzles however should be such that the nozzle is no wider than the pressurized membrane width, to minimize board to board spacing, yet have maximum cross sectional area to maintain fluid flow. The nozzles illustrated in figure 2 are oval in shape to meet this criteria and facilitate a board to board pitch of 5 mm (200 mils) as shown in figure 1.

The coolant membrane 35 is formed of 0.05 mm (2 mil) thick polyether based polyurethane film. The choice of the membrane material depends on the relative importance to the system under consideration of the factors associated with the material. The polyurethane film is inexpensive, easy to heat seal, very conformable, and has high strength. Systems requiring even higher heat transfer than the polyurethane material could easily employ metal/plastic laminates as the membrane material. A laminate is a series of metal foils interposed between a series of polyurethane films. The laminate would have higher thermal conductivity but lower conformability. Other materials useful for membrane materials are parylene film, fluorohalocarbon, and plastic reinforced etched metal foil. The choice of the membrane material will also be influenced by the choice of the coolant material. Coolant membrane 35 uses water as the cooling fluid. Water does not react with the polyether based polyurethane and so is compatible with the membrane material. Other possible cooling fluids such as fluorocarbon, silicon oil, or liquid nitrogen, etc., may adversely react with the membrane material and degrade either the cooling fluid or the membrane material and therefore detract from the cooling efficiency of the system. The coolant membrane 35 may also have a metal wool type filler of highly thermally conductive material such as aluminum, copper, or stainless steel. The natural spring force of this material against the inner membrane walls will enhance the thermal conductivity of the membrane walls. Such a thermal enhancement is useful with either a polymer or metal type membrane material.

The integrated circuit boards 15, 20, and 25 are connected on a top edge to motherboard 10 via edge connections 27, 29, and 31 respectively. The edge connectors are elastomeric type high density edge connectors which are common in the art. These connectors physically allow close spacing between circuit boards. The connectors 27 are attached to motherboard 10 and interconnect circuit patterns formed on motherboard 10 to other connectors such as connectors 29 or 31. Similarly, motherboards 4, 6, and 8 also interconnect edge connectors 27, 29, and 31 with each other, with other edge connectors, and with the circuit boards. The physical dimensions of the package are reduced because air space between boards is not required for relatively inefficient air cooling. Interconnectivity is increased because board edges are not used for providing air flow into and out of the space between the circuit boards. Therefore, the boards have connections on all four edges, rather than two. Increasing interconnectivity also further decreases the package dimensions. Typically, the spacing can be reduced to a 5 mm (200 mil) circuit board pitch with each board having 1.5 mm (60 mil) high electrical components as illustrated in figure 1.

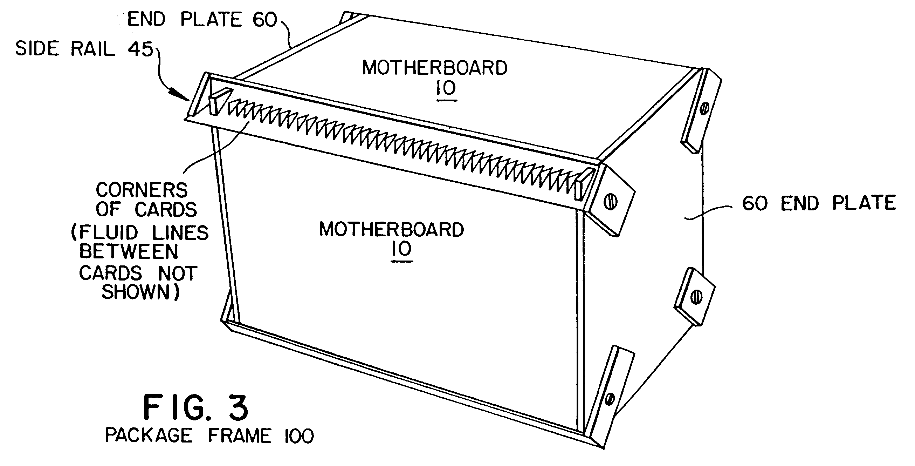

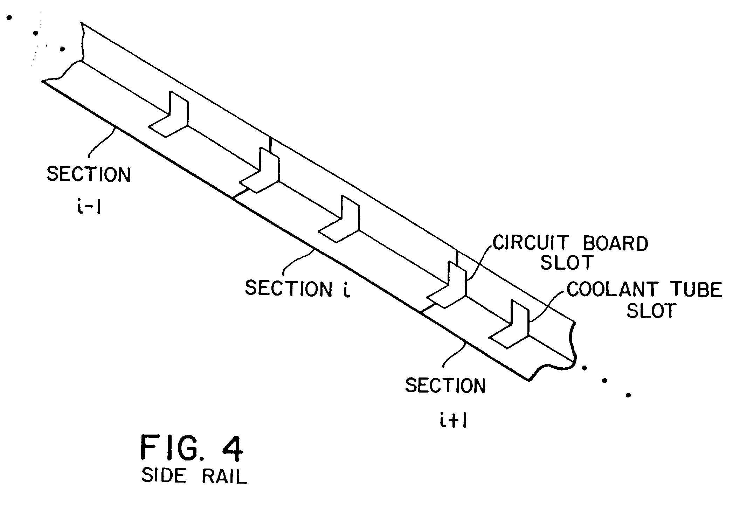

The circuit boards and motherboards are structurally connected by four side rails 45 and two end plates 60 to form a package frame 100 as shown in Figure 3. The side rails 45 form a three dimensional structure by their attachment to the two end plates 60. The oppositely facing end plates 60 have their respective corners joined by the side rails 45. Each side rail 45 joins the edges of two motherboards 10 such that four motherboards 10 joined edge to edge by four side rails 45 enclose a volume. The side rails 45 have a ninety degree angled crossection and may be made of extruded aluminum or the like. Each side rail is formed of a plurality of longitudinal sections, and each section is removably joined by a screw or other means to its two adjacent sections. This is illustrated in figure 4 in which sections i-1, i, and i+1 are joined end to end to form the side rail 45. This embodiment has one board per section however more boards per section may be used. Each connection between sections also form a slot to provide structural support for a single board at a corner of the board. The slots properly space the individual boards and provide additional structural support for the boards beyond that of the edge connectors. Each section of side rail 45 has an opening 47 for a coolant tube from the membrane. If more than one board per section is used, more slots for coolant tubes must also be provided in order to maintain a coolant membrane between each board. In order to remove a board, the side rails 45 are detached at the section for the board. The integrity of the cooling system is not affected by this action because the cooling to each board is maintained by individual membranes.

Therefore there has been described a way of improving the packaging density of electronic devices, primarily by efficiently and uniformly cooling closely packed circuit boards without coolant fluid physically contacting circuit card components, thereby increasing the interconnectivity between circuit boards and reducing signal delay times between circuits on closely packed circuit boards.

## Claims

1. Electrical apparatus with a cooling system for cooling spaced circuit boards, comprising;
a plurality of circuit boards (15, 20, 25); and
a plurality of coolant membranes (35, 40), each having at least one inlet and at least one outlet tube (50, 52, 54, 56) for circulating a coolant fluid through said coolant (35, 40) membrane;
each said coolant membrane having opposing conformable walls for at least partially conforming under pressure to the surface topology of respective opposing surfaces of said circuit boards;
a plurality of motherboards (4, 6, 8, 10), each of said motherboards having a plurality of connections (27, 29, 31) for connecting at least one edge of each of said circuit boards to said motherboard;
a frame supporting said circuit boards and said motherboards, said frame having a plurality of side rails (45) attaching adjacent motherboard edges together forming a housing to enclose said plurality of circuit boards; and in that
each said coolant membrane (35, 40) being interposed in a gap formed by two adjacent circuit boards;
the arrangement being such that in operation circulation of said coolant fluid pressurizes said coolant membranes between said circuit boards to conform said opposing walls to said surface topology of said circuit boards.

2. Electrical apparatus as claimed in claim 1, wherein:
the width of said inlet and outlet tubes (50, 52, 54, 56) is less than said gap width between said opposing surfaces of said adjacent circuit boards (15, 20, 25);
said circuit boards are substantially rectangular in shape; and
said inlet and outlet tubes are disposed substantially at said circuit board corners to permit interconnection between said boards on four edges of said circuit boards.

3. Electrical apparatus as claimed in any preceding claim, wherein
said coolant membrane material is selected from the group consisting of polyurethane, fluorohalocarbon, and metal/plastic laminate.

4. Electrical apparatus as claimed in any preceding claim, wherein:
said coolant fluid is selected from the group consisting of air, water, fluorocarbon, silicon oil, and liquid nitrogen.

5. Electrical apparatus as claimed in any preceding claim, wherein:
said coolant membrane (35, 40) contains metal wool filler to enhance said coolant membrane thermal conductivity.

6. Electrical apparatus as claimed in any preceding claim, wherein:
each of said side rails (45) comprises a plurality of sections;
each of said sections corresponds to one of said plurality of circuit cards attached to said motherboard;
each of said sections attaches to adjacent sections; and
each of said sections is removable from said housing to enable removal from said housing of said circuit card corresponding to said section.

## Patentansprüche

1. Elektrisches Gerät mit einem Kühlsystem zur Kühlung von in einem Abstand voneinander angeordneten Schaltkarten, das folgendes umfaßt:
Eine Vielzahl von Schaltkarten (15, 20, 25), und
Eine Vielzahl von Kühlmittelmembranen (35, 40), die jeweils mindestens eine Einlaßröhre und mindestens eine Auslaßröhre (50, 52, 54, 56) zur Umwälzung eines Kühlmittelfluids durch die Kühlmittelmembran (35, 40) aufweisen;
Wobei jede Kühlmittelmembran gegenüberliegende, formanpassende Wände aufweist, um sich bei Druckbeaufschlagung zumindest teilweise der Oberflächentopologie der jeweiligen gegenüberliegenden Oberflächen der Schaltkarten anzupassen;
Mehrere Hauptplatinen (4, 6, 8, 10), wobei jede der Hauptplatinen eine Vielzahl von Anschlüssen (27, 29, 31) zur Verbindung von mindestens einer Kante jeder Schaltkarte mit der Hauptplatine aufweist;
Einen Rahmen, der die Schaltkarten und Hauptplatinen aufnimmt, wobei der Rahmen eine Vielzahl von Seitenschienen (45) aufweist, die benachbarte Hauptplatinenkanten miteinander verbinden und ein Gehäuse bilden, das die Vielzahl von Schaltkarten einschließt, und wobei:
Jede Kühlmittelmembran (35, 40) in einem Spalt angeordnet ist, der von zwei benachbarten Schaltkarten gebildet wird;
Wobei die Anordnung dergestalt ist, daß während des Betriebs aufgrund der Umwälzung des Kühlmittelfluids Druck auf die Kühlmittelmembranen zwischen den Schaltkarten beaufschlagt wird, der bewirkt, daß sich die gegenüberliegenden Wände der Oberflächentopologie der Schaltkarten anpassen.

2. Elektrisches Gerät wie in Patentanspruch 1 offenbart, bei dem:
Die Breite der Einlaß- und der Auslaßröhren (50, 52, 54, 56) geringer als die Spaltbreite zwischen gegenüberliegenden Oberflächen der benachbarten Schaltkarten (15, 20, 25) ist;
Die Schaltkarten eine im wesentliche rechteckige Form aufweisen; und
Die Einlaß- und Auslaßröhren im wesentlichen an den Ecken der Schaltkarten angeordnet sind, um eine Verdrahtung zwischen den Schaltkarten an vier Kanten der Schaltkarten zu gestatten.

3. Elektrisches Gerät wie in einem beliebigen der vorstehenden Patentansprüche offenbart, bei dem:
Das Material für die Kühlmittelmembran aus der Gruppe ausgewählt wird, die Polyurethan, Fluorhalogenkohlenwasserstoff sowie Metall-/Kunststofflaminat einschließt;

4. Elektrisches Gerät wie in einem beliebigen der vorstehenden Patentansprüche offenbart, bei dem:
Das Kühlmittelfluid aus der Gruppe ausgewählt wird, die Luft, Wasser, Fluorkohlenwasserstoff, Siliziumöl und flüssigen Stickstoff einschließt.

5. Elektrisches Gerät wie in einem beliebigen der vorstehenden Patentansprüche offenbart, bei dem:
Die Kühlmittelmembran (35, 40) einen Füllstoff aus Metallwolle enthält, um die thermische Leitfähigkeit der Kühlmittelmembran zu verbessern.

6. Elektrisches Gerät wie in einem beliebigen der vorstehenden Patentansprüche offenbart, bei dem:
Jede der Seitenschienen (45) eine Vielzahl von Profilen umfaßt;
Jedes der Profile einer der Vielzahl von Schaltkarten entspricht, die mit der Hauptplatine verbunden sind;
Jedes der Profile mit benachbarten Profilen verbunden ist; und
Jedes der Profile von dem Gehäuse abnehmbar ist, um den Ausbau der dem Profil entsprechenden Schaltkarte aus dem Gehäuse zu ermöglichen.

## Revendications

1. Appareil électrique avec un système de refroidissement pour refroidir des cartes à circuit espacées, comprenant:
une pluralité de cartes à circuit (15, 20, 25); et
une pluralité de membranes de refroidissement (35, 40), comportant chacune au moins un tube d'entrée et au moins un tube de sortie (50, 52, 54,56) pour faire circuler un fluide réfrigérant à travers ladite membrane de refroidissement (35, 40);
chacune desdites membranes de refroidissement ayant des parois opposées pouvant être conformées pour au moins se conformer partiellement sous une pression à la topologie de surface des surfaces opposées respectives desdites cartes à circuit;
une pluralité de cartes mères (4, 6, 8, 10) chacune desdites cartes mères ayant une pluralité de connexions (27, 29, 31) pour connecter au moins un bord de chacune desdites cartes à circuit à ladite carte mère;
un châssis supportant lesdites cartes à circuit et lesdites cartes mères, ledit châssis ayant une pluralité de rails latéraux (45) reliant les bords adjacents des cartes mères ensemble pour former un boîtier logeant ladite pluralité de cartes à circuit; et en ce que
chacune desdites membranes de refroidissement (35, 40) est interposée dans un intervalle formé par deux cartes à circuit adjacentes;
l'agencement étant tel que lors du fonctionnement, la circulation dudit fluide réfrigérant met sous pression lesdites membranes de refroidissement entre lesdites cartes à circuit pour conformer lesdites parois opposées à ladite topologie de surface desdites cartes à circuit.

2. Appareil électrique selon la revendication 1, dans lequel:
la largeur desdits tubes d'entrée et de sortie (50, 52, 54, 56) est inférieure à ladite largeur de l'intervalle entre lesdites surfaces opposées desdites cartes à circuit adjacentes (15, 20, 25);
lesdites cartes à circuit ont une forme sensiblement rectangulaire; et
lesdits tubes d'entrée et de sortie sont disposés sensiblement aux coins de la carte à circuit pour permettre l'interconnexion entre lesdites cartes sur les quatre bords desdites cartes à circuit.

3. Appareil électrique selon l'une quelconque des revendications précédentes, dans lequel
ledit matériau de la membrane de refroidissement est sélectionné dans le groupe consistant en polyuréthane, fluorohalocarbone, et couche de métal/matière plastique.

4. Appareil électrique selon l'une quelconque des revendications précédentes, dans lequel:
ledit fluide réfrigérant est sélectionné dans le groupe consistant en air, eau, fluorocarbone, huile de silicone, et azote liquide.

5. Appareil électrique selon l'une quelconque des revendications précédentes dans lequel:
ladite membrane de refroidissement (35, 40) contient un agent de remplissage en laine métallique pour améliorer la conductivité thermique de la membrane de refroidissement.

6. Appareil électrique selon l'une quelconque des revendications précédentes, dans lequel:
chacun desdits rails latéraux (45) comprend une pluralité de sections;
chacune desdites sections correspond à l'une de ladite pluralité de cartes à circuit fixées à ladite carte mère;
chacune desdites sections est fixée aux sections adjacentes; et
chacune desdites sections peut être retirée du boîtier pour permettre le retrait dudit boîtier de ladite carte à circuit correspondant à ladite section.
